Europäisches Patentamt

European Patent Office

Office européen des brevets

(11) Publication number: **0 272 027**
**A2**

## EUROPEAN PATENT APPLICATION

(21) Application number: 87310724.7

(22) Date of filing: 07.12.87

(51) Int. Cl.⁴: **H05K 1/00** , G02B 5/00

(30) Priority: 15.12.86 US 941490
15.12.86 US 941491

(43) Date of publication of application:
**22.06.88 Bulletin 88/25**

(84) Designated Contracting States:
**AT BE CH DE FR GB IT LI NL SE**

(71) Applicant: **AMERICAN TELEPHONE AND TELEGRAPH COMPANY**
**550 Madison Avenue**
**New York, NY 10022(US)**

(72) Inventor: **Gabbard, Larry Joe**
**11555 W. 78th Drive**
**Arvada Colorado 80005(US)**

(74) Representative: **Johnston, Kenneth Graham et al**
**Western Electric Company Limited 5 Mornington Road**
**Woodford Green Essex, IG8 OTU(GB)**

(54) Printed circuit board.

(57) This printed circuit board (200) with optical signal distribution layer (101, 102) uses a layer of transparent material or an optical fiber mat build into the laminated printed circuit board structure to interconnect various opto-electrical devices (110,111) which are attached to the surface of the printed circuit board.

The optical devices are connected to the buried optical fiber layer by drilling vias in the printed circuit board to intercept the fiber or the particular optical signal distribution layer at a desired location. The via is then filled with an optical material (210) whose optical properties provide for the coupling of light energy from the intercepted optical signal distribution layer through the via material to the surface of the printed circuit board. Opto-electrical devices are connected over the top of these vias and perform the optical light energy to electrical signal conversion function.

FIG.1

## PRINTED CIRCUIT BOARD

This invention relates to printed circuit boards.

It is a problem to interconnect optical devices on a printed circuit board. These optical devices are generally interconnected by routing individual optical fibers along the surface of the printed circuit board. These optical fibers are usually not attached in any way to the printed circuit board and are thus exposed to damage in manufacturing and handling of the printed circuit board.

According to one aspect of the present invention, there is provided a method of manufacturing a circuit board, comprising the step of arranging optical signal distribution means relative to a component layer characterised by laminating at least another layer of circuit board to the said component layer to cover the said distribution means, and forming at least one via of optical transmission material through at least one of the said layers between the said distribution means and the surface of the circuit board.

According to another aspect of the invention, there is provided a printed circuit board comprising a component layer, and optical signal distribution means secured to the said component layer, characterised by at least another layer of circuit board laminated to the component layer and covering the said distribution means, and at least one via of optical transmission material extending through at least one of the layers between the distribution means and the surface of the circuit board.

The above problem is solved and a technical advance is achieved in the present invention by providing a printed circuit board with at least one optical signal distribution means. In one embodiment of the invention the optical signal distribution means comprises one or more individual optical fibers buried in the printed circuit board structure to interconnect with the optical devices that are attached to the printed circuit board. During the manufacturing process these optical fibers are positioned relative to and preferably secured to a component layer and then laminated with the other component layers to become part of the printed circuit board structure.

In another embodiment of the invention, the optical signal distribution means comprises at least one optical signal distribution layer. The distribution layer is a layer of transparent material or an optical fiber mat built into the laminated printed circuit board structure to interconnect various opto-electrical devices which are attached to the surface of the printed circuit board.

The optical devices mounted on the surface of the printed circuit board are connected to the buried optical fibers or the distribution layer by drilling a via or vias in the printed circuit board to intercept an optical fiber or fibers or the layer or layers. The via is then filled with an optical material whose optical properties couple the light energy from the intercepted optical fiber or distribution layer through the via material to the surface of the printed circuit board. The optical device(s) is attached to the surface of the printed circuit board over the via(s). The optical device contains an opening in the bottom thereof so that light energy can be transmitted from or received from the via by the bottom side of the optical device. Received light is converted into electrical signals.

In this fashion, the printed circuit board with optical signal distribution layer avoids the problem of having individual optical fibers interconnect optical devices on the surface of the printed circuit board. The buried optical fibers or optical distribution layer are not subject to damage in manufacturing or handling of the printed circuit board. This arrangement also provides an improved structure for terminating the optical distribution layer or optical fibers on an optical fiber connector.

The invention may be better understood from a reading of the following description of two embodiments taken into conjunction with the drawing, in which:

FIG. 1 illustrates the structure of the printed circuit board with optical signal distribution layer;

FIG. 2 illustrates in cross sectional form the structure of one of the optical vias;

FIG. 3 illustrates, in exploded form, the structure of the second embodiment showing the printed circuit board with the optical signal distribution layer; and

FIG. 4 illustrates, in a cross sectional view, the structure of the optical vias of the second embodiment.

An epoxy glass printed circuit board is normally constructed from one or more layers, called component layers, of epoxy glass material. Each component layer in an epoxy glass printed circuit board is fabricated from a plurality of glass mats. The glass mats are impregnated with epoxy adhesive and stacked one on top of the other to form the component layer. The glass mats form a rigid matrix once the epoxy adhesive cures. Electrically conductive paths can be added to the top and bottom surfaces of the component layer by laminating a copper coating on the top and bottom surfaces of the component layer. The copper coating can then be etched in well known fashion to create electrically conductive paths.

In a multi-layer printed circuit board, a plurality of component layers are glued together with an adhesive commonly referred to as B-stage epoxy adhesive. This B-stage epoxy adhesive is applied to mating surfaces of the component layers and the resulting structure is subjected to the application of heat and pressure to cure the adhesive and form a unitary multi-layer printed circuit board structure.

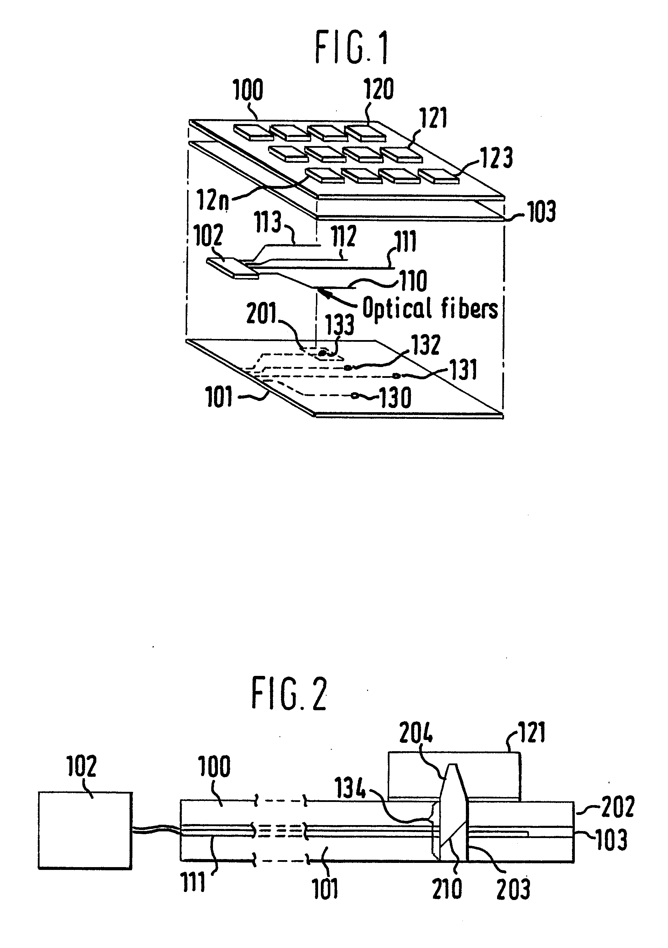

FIG. 1 illustrates the printed circuit board in which optical fibers form the optical signal distribution means. This printed circuit board is displayed in FIG. 1 in exploded form wherein the board is constructed of two printed circuit board component layers 100 and 101. One or both of these printed circuit board component layers carry the circuit elements which are to be interconnected by the electrically and optically conductive paths of the printed circuit board. FIG. 1 illustrates a plurality of circuit elements 120-12n attached to the surface of printed circuit board component layer 100. Likewise, a plurality of circuit elements can be attached to the bottom surface of printed circuit board component layer 101 and the outline of one such device 201 is illustrated in FIG. 1. These devices can be electrical devices and/or opto-electrical devices. Printed circuit board component layer 100 carries numerous electrically conductive paths (not shown) in the top surface thereof to interconnect the input and output terminals of the various electrical devices attached to the top surface of printed circuit board component layer 100. One or more of the devices attached to printed circuit board component layer 100 can be opto-electrical devices, which perform a signal conversion function between electrical signals and optical signals.

In addition to printed circuit board component layers 100 and 101, an optical fiber connector 102 is shown with four optical fibers 110-113 connected thereto. Printed circuit board component layer 101 has illustrated on the top surface thereof four dotted lines which indicate the pattern in which the optical fibers connected to optical fiber connector 102 are arranged on the surface of printed circuit board component layer 101. In manufacturing the printed circuit board with optical signal distribution layer, printed circuit board component layer 101 is arranged to have the four optical fibers 110-113 secured to the top surface thereof. The method of arranging the optical fibers to the surface of printed circuit board component layer 101 is preferably done with an adhesive. Each of the optical fibers 110-113 is adhesively bonded in a predetermined pattern of the top surface of printed circuit board component layer 101. A layer 103 of B-stage epoxy adhesive is applied to either the top surface of component layer 101 or the bottom surface of component layer 100. Printed circuit boards component layer 100 is then laminated on top of the optical fibers 110-113 attached to the top surface of printed circuit board component layer 101 thereby producing a multilayer circuit board in which the optical fibers are sandwiched between printed circuit board component layers 100 and 101.

Printed circuit board component layer 101 contains one or more holes or vias drilled through the printed circuit board component layer. Each of the holes 130-133 is drilled through the printed circuit board component layer to intersect or interact with a respective one of optical fibers 110-113. These holes or vias are then filled with an optical material so that any light energy carried by one of the optical fibers intercepted by the via would be transmitted through the optical material to the surface of the printed circuit board component layer.

FIG. 2 illustrates a cross sectional view of an optical via 203 through an assembled printed circuit board. Printed circuit board component layers 100 and 101 sandwich B-stage epoxy adhesive 103 and the plurality of optical fibers, one of which (111) is shown on FIG. 2. The unitary structure that results from the lamination of printed circuit board component layer 100 to component layer 101 results in a printed circuit board 202. The optical via 203 shown in FIG. 2 is exaggerated in its dimensions to illustrate the concept of the subject invention. Optical via 203 is drilled through the top surface of printed circuit board 202 to intersect optical fiber 111. Optical material 204 is then cast into optical via 203 to carry the light energy from the optical fiber 111 to the top surface of printed circuit board 202. The optical via can be drilled to just intersect optical fiber 111 or can be drilled all the way through printed circuit board 202 and a mirrored plug 210 inserted therein from the bottom of the printed circuit board to reflect the light energy carried by optical fiber 111 up to the top surface of the printed circuit board 202 through optical material 204. In either case, the light energy is carried from optical fiber 111 through optical material 204 to opto-electrical device 121. Alternatively, optical energy can be generated in device 121 and carried to fiber 111. As described above, opto-electrical device 121 has an opening in the bottom thereof where light energy from the optical material 204 can be transmitted into the inside of opto-electrical device 121. Opto-electrical device 121 contains well known optical to electrical conversion circuitry which converts signals between an electrical format and the light energy carried or to be carried by optical fiber 111.

In this embodiment, optical fiber or fibers are buried in the structure of printed circuit board 202 to become part of the unitary printed circuit board and is therefore not exposed to handling or manufacturing. Optical fibers 110-113 can be pigtailed off the end of printed circuit board 202 to connect to an optical fiber connector 102. The optical fibers 110-113 could be completely encapsulated by the printed circuit board and the epoxy board material etched away at the very end of the assembly process to expose optical fibers 110-113 for connection to optical fiber connector 102.

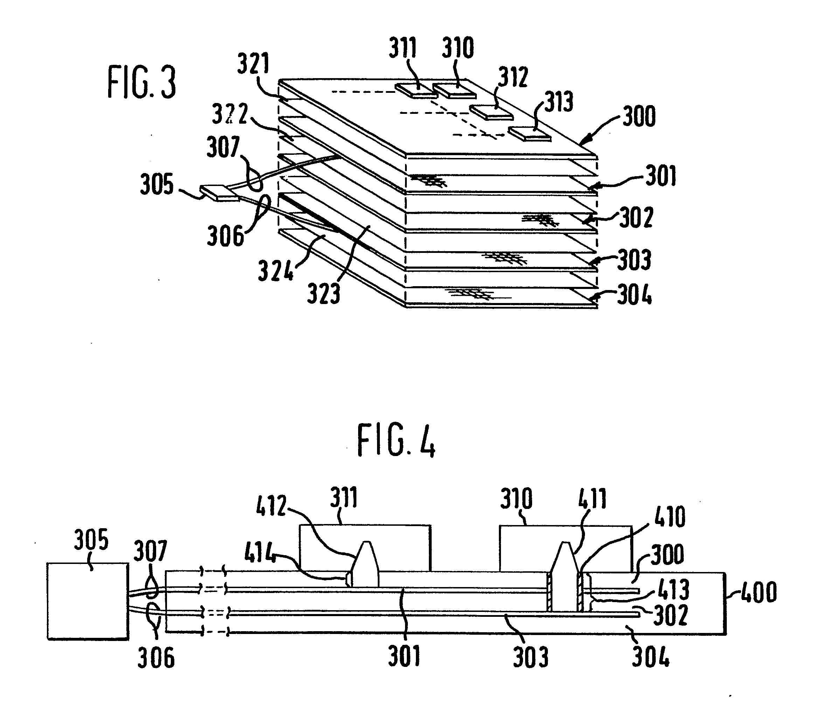

FIG. 3 illustrates, in exploded diagram form, the structure of the printed circuit board with two optical signal distribution layers, although only one such layer could be employed. The printed circuit board consists of two printed circuit board layers 300, 304 which comprise the top and bottom layers of the printed circuit board. Printed circuit board layers 300, 304 can be either component layers, described above, or optical fiber mats. To simplify the description, printed circuit board layers 300, 304 are assumed to be component layers. Printed circuit board component layers 300 and 304 are the printed circuit board layers to which the various electrical and opto-electrical devices are attached. In addition, the printed circuit board includes at least one signal distribution means in the form of one or more optical signal distribution layers 301, 303 which can be either optical fiber mats or layers of optically transparent material.

If optical fiber mats are used to implement optical signal distribution layers 301,303, the optical fiber mats must be bonded such as by diffusion prior to printed circuit board assembly. The optical fiber mats consist of a X-Y matrix of interwoven optical fibers. To provide an optical signal distribution layer, the optical fibers in the optical fiber mat are diffusion bonded at a sufficient number of X-Y intersections so that optical signals can be coupled throughout the optical fiber mat. The diffusion bonding at these X-Y intersections couples the optical signals from one optical fiber to another and also provides additional mechanical stability to the optical fiber mat.

These optical signal distribution layers 301, 303 are separated from each other by an opaque layer of material 302. The opaque layer of material 302 is inserted between optical signal distribution layers 301, 303 to prevent any light coupling between optical signal distribution layers 301, 303. Optical signal distribution layers 301-303 are then interspersed with layers of B-stage epoxy adhesive 321-324 and sandwiched between printed circuit board component layers 300, 304 and the entire structure is laminated together to create a unitary structure having, in the exemplary embodiment, two optical signal distribution layers 301,303. The optical signal distributions layers 301, 303 can be connected via optical fiber pigtail leads 306, 307 to an optical fiber connector 305.

A number of electrical and opto-electrical devices 310-313 are shown on FIG. 3 to illustrate the location of the various devices attached to the top surface of component layer 300 of the printed circuit board. Devices such as 310-313 can be attached to printed circuit board component layer 300 as well as printed circuit board component layer 304. Various electrically conductive paths (not shown) are also attached to the surface of printed circuit board component layers 300, 304 in well known fashion to interconnect the input and output electrical terminals of the various devices 310-313 attached to the surface of printed circuit board component layers 300, 304. One or more devices 310-313 attached to the surface of printed circuit board component layer 300 can be opto-electrical devices which perform a signal conversion function to convert between optical light energy carried by the optical signal distribution layer and the electrical signals transmitted via the electrically conductive paths to various electrical devices attached to the surface of printed circuit board component layer 300 or 304.

FIG. 4 illustrates across sectional view of two optical vias drilled through the printed circuit board component layer 300. Optical via 414 shown on the left side of FIG. 4 is drilled through printed circuit board component layer 300 to optical signal distribution layer 301. This optical signal distribution layer can be a matrix of optical fibers or a layer of transparent material which conducts light energy throughout that layer of the printed circuit board. Optical material 412 fills via 414 and has optical properties such that the light energy in optical signal distribution layer 301 is coupled through the optical material 412 to the surface of printed circuit board component layer 300. Optical device 311 is connected to the top surface of printed circuit board component layer 300 directly over optical via 414. Opto-electrical device 311 contains an opening in the bottom thereof so that light energy carried to the surface of the printed circuit board by optical material 412 enters the opening in opto-electrical device 311 and is converted therein into electrical signals.

In similar fashion, opto-electrical device 310 on the right hand side of FIG. 4 covers optical via 413 drilled through printed circuit board component layer 300, optical signal distribution layer 301, opaque layer 302 to optical signal distribution layer 303. An opaque material 410 is used to coat the sides of this via so that light energy from optical signal distribution layer 301 does not enter via 413. Optical material 411 fills via 413 so that the light energy can be transmitted between optical signal distribution layer 303 and device 310 through optical material 411. As with opto-electrical device 311, opto-electrical device 310 converts light energy transmitted through optical signal distribution layer 303 and optical material 411 into electrical signals for transmission over the electrically conductive paths on the surface of printed circuit board component layer 310 to various others of the devices attached thereto.

## Claims

1. A method of manufacturing a circuit board, comprising the step of arranging optical signal distribution means (110 to 113 or 303) relative to a component layer (101 or 304), CHARACTERISED BY laminating at least another layer (100) of circuit board to the said component layer to cover the said distribution means, and forming at least one via (130) of optical transmission material (204) through at least one of the said layers between the said distribution means and the surface of the circuit board.

2. A method according to claim 1, CHARACTERISED IN THAT the distribution means is secured to the said component layer prior to the lamination step.

3. A method according to claim 1 or 2, CHARACTERISED IN THAT the distribution means comprises a plurality of optical fibers (110 to 113) with a via (130 to 133) intersecting with each repective fiber.

4. A method according to claim 3, CHARACTERISED IN THAT a mirrored plug (210) forms each via.

5. A method according to claim 1 or 2, CHARACTERISED IN THAT the distribution means comprises at least one layer of transparent material or at least one optical fiber mat of interwoven fibers, and in that each via extends from a transparent layer or mat to a component on the component layer.

6. A printed circuit board comprising a component layer (101, 304), and optical signal distribution means (110 to 113 or 303) secured to the said component layer, CHARACTERISED BY at least another layer (100) of circuit board laminated to the component layer and covering the said distribution means, and at least one via (130) of optical transmission material (412) extending through at least one (300) of the layers between the distribution means and the surface of the circuit board.

7. A printed circuit board according to claim 6, CHARACTERISED IN THAT an opto-electrical device (121) is located on the circuit board surface and over a respective via.

8. A circuit board according to claim 6 or 7, CHARACTERISED IN THAT the distribution means comprises a plurality of optical fibers (110 to 113) with a via (130 to 133) intersecting with each fiber.

9. A circuit board according to claim 6 or 7, CHARACTERISED IN THAT the distribution means comprises at least one layer of transparent material (103) or at least one optical fiber mat of interwoven fibers, and in that each via extends from a transparent layer or mat to a component (411) on the component layer.

10. A circuit board according to claim 8, CHARACTERISED IN THAT a mirrored plug (210) forms each via.

# FIG.1

100    120

121

123

12n    103

113    112    111

102    110

Optical fibers

201    133    132

131

101    130

# FIG.2

204    121

102    100    134    202

103

111    101    210    203

FIG.3

311 310
321
322 312
307 313
305 300
306
301
324 302
323 303
304

FIG.4

412 311 310 411 410
305 307 414 300
413 400
306 302
301 303 304